# EUROPÄISCHE PATENTANMELDUNG

(11) **EP 0 849 985 A2**
(43) Veröffentlichungstag der Anmeldung: **24.06.1998**
(21) Anmeldenummer: 97120227.0
(22) Anmeldetag: 19.11.1997
(51) Int. Cl.: H05K 7/14

(54) **Trägerplatte für eine Platine mit elektronischen Bauelementen**

(30) Priorität: 21.11.1996 DE 19648205
(71) Anmelder: Hermann Stahl GmbH, 71723 Grossbottwar (DE)
(72) Erfinder: Stahl, Hermann, 71711 Steinheim/Kleinbottwar (DE)
(74) Vertreter: Wasmuth, Rolf, Dipl.-Ing.

(57) **Zusammenfassung**

Die Erfindung betrifft eine Trägerplatte mit Abstandshaltern für eine etwa parallel zur Trägerplatte (1) festzulegende Hauptplatine eines Computers, wobei jeder Abstandshalter (2) mit einem Fuß (20) an einem Befestigungspunkt (5) auf der zugewandten Seite (4) der Trägerplatte (1) festliegt und mit einem Kopf (22) an einem vorgegebenen Befestigungspunkt der Platine (3) festzulegen ist. Um einen einfach ausgebildeten, werkzeuglos an vorgebbaren Stellen der Trägerplatte (1) zu montierenden Abstandshalter (2) zu schaffen, ist vorgesehen, den Fuß (20) des Abstandshalters (2) plattenartig auszubilden und den etwa parallel zur Trägerplatte (1) liegenden plattenartigen Fuß (20) an mindestens zwei Kanten (20a, 20b) von Haltenasen (10, 11) der Trägerplatte (1) zu übergreifen, wobei der Fuß (20) in dieser übergriffenen Lage durch Anschlagnasen (14, 15) der Trägerplatte (1) gesichert ist.

## Beschreibung

Die Erfindung betrifft eine Trägerplatte mit Abstandshaltern für eine etwa parallel zur Trägerplatte festzulegende Platine mit elektronischen Bauelementen nach dem Oberbegriff des Anspruchs 1.

Derartige Trägerplatten werden zum Beispiel in Computergehäusen zur Halterung der Hauptplatine (Main Board) verwendet. Die Trägerplatine soll nicht nur das Main Board im Computergehäuse sicher fixieren, sondern sie muß auch die beim Einsetzen oder Austauschen von Steckkarten auftretenden Kräfte sicher abfangen. Dabei spielt insbesondere die Anordnung der Befestigungspunkte zwischen der Trägerplatte und der Platine mit den elektronischen Bauelementen eine wesentliche Rolle. Die möglichen Befestigungspunkte lassen sich aber nicht allein nach den mechanischen Anforderungen setzen, sondern sie müssen auch nach den von der Anordnung der elektronischen Bauelemente noch freien Bereichen ausgewählt werden. Dies führt dazu, daß die Main Boards unterschiedlicher Hersteller bzw. unterschiedlicher Konfiguration (AT, ATX) unterschiedliche Lagen der Befestigungspunkte aufweisen können. Entsprechend sind dann auch die Befestigungspunkte auf der Trägerplatine zu wählen.

Zur Befestigung einer Platine an den ausgewählten Punkten der Trägerplatte werden Abstandshülsen verwendet, in die sowohl von der Seite der Trägerplatte als auch von der Seite der Platine eine Gewindeschraube eingedreht wird. Die Herstellung als auch die Montage der Abstandshalter sind dabei zeit- und kostenaufwendig.

Der Erfindung liegt die Aufgabe zugrunde, eine gattungsgemäße Trägerplatte derart auszubilden, daß einfach ausgebildete Abstandshalter mit geringem Montageaufwand an ausgewählten Befestigungspunkten der Trägerplatte festgelegt werden können.

Die Aufgabe wird erfindungsgemäß nach den kennzeichnenden Merkmalen des Anspruchs 1 gelöst.

Ein plattenartiger Fuß des Abstandshalters kann in einfacher Weise durch prägen an dem Abstandshalter angeformt werden, so daß der Abstandshalter kostengünstig als Massenteil hergestellt werden kann. Das Einschieben des plattenartigen Fußes unter die Haltenasen der Trägerplatte und die Sicherung des Fußes durch Anschlagnasen der Trägerplatte gewährleistet eine werkzeuglose Montage, so daß nicht nur bei der Fertigung, sondern auch bei einem späteren Umrüsten ein nur minimaler Aufwand zur Anordnung der den Befestigungspunkten der Platine zugeordneten Abstandshalter möglich ist.

Bevorzugt sind die Nasen, also sowohl die Haltenasen als auch die Anschlagnasen, aus der Trägerplatte ausgeprägt. So können bei der Herstellung der Trägerplatte durch prägen gleichzeitig eine Vielzahl von Befestigungspunkten für eine Vielzahl unterschiedlicher Platinen vorgesehen werden. Das Prägen der Nasen schwächt die Trägerplatte nicht, so daß auch bei einer Vielzahl von Befestigungspunkten auf der Trägerplatte deren mechanische Stabilität nicht beeinträchtigt ist.

Bevorzugt ist eine der Anschlagnasen von dem vorderen Ende einer ausgeprägten Federzunge gebildet, welche den Abstandshalter in einer Montagestellung sichert. Durch die Federzunge wird der Abstandshalter in den Montagesitz eingeklipst.

Bevorzugt ist der plattenartige Fuß des Abstandshalters etwa rechteckig, insbesondere quadratisch ausgebildet. Dabei umgibt der plattenartige Fuß als Rahmen das untere Ende einer zylindrischen Hülse, wobei der Kopf des Abstandshalters durch das nach innen eingerollte Ende der Hülse gebildet ist. Der Abstandshalter mit seinem Fuß und dem Kopf kann in dieser Form einteilig aus einem Blech geprägt sein, so daß der Abstandshalter mit geringem Aufwand als Massenteil herstellbar ist.

Bevorzugt liegen die Nasen in der Ebene der Trägerplatte, das heißt, die Nasen stehen nicht über die der Platine zugewandte Außenseite der Trägerplatte vor. Der so ausgebildete Montagesitz nimmt keinen Bauraum zwischen der Trägerplatte und der Platine ein, so daß auch bei einer engen Montage der Platine an der Trägerplatte ein ausreichender Luftraum zur Kühlung der Bauelemente verbleibt. Die enge Montage stellt auch sicher, daß die Gesamtanordnung aus Trägerplatte und Platine innerhalb des PC-Gehäuses nur geringen Bauraum beansprucht.

Bevorzugt ist der Montagesitz für den Fuß des Abstandshalters in die Trägerplatte eingeprägt.

Weitere Merkmale der Erfindung ergeben sich aus den weiteren Ansprüchen, der Beschreibung und der Zeichnung, in der nachfolgend im einzelnen beschriebene Ausführungsbeispiele der Erfindung dargestellt sind. Es zeigen:
- Fig. 1: eine Draufsicht auf eine erfindungsgemäße Trägerplatte,
- Fig. 2: eine Seitenansicht der Trägerplatte nach Fig. 1 mit darauf befestigter Platine,

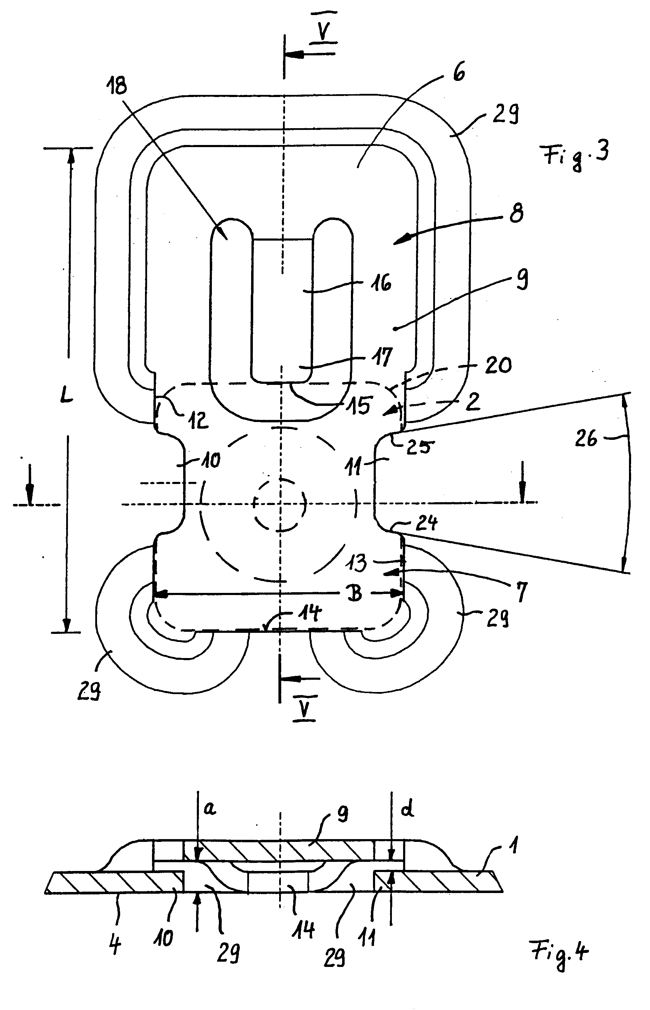

- Fig. 3: eine Draufsicht auf einen Montagesitz der Trägerplatte gemäß Einzelheit III in Fig. 1,
- Fig. 4.: einen Schnitt längs der Linie IV-IV in Fig. 3,
- Fig. 5: einen Schnitt längs der Linie V-V in Fig. 3,
- Fig. 6: eine Draufsicht auf einen Montagesitz der Trägerplatte gemäß Einzelheit VI in Fig. 1,
- Fig. 7: eine Ansicht des Montagesitzes gemäß Pfeil VII in Fig. 6,
- Fig. 8: einen Schnitt längs der Linie VIII-VIII in Fig. 6,
- Fig. 9: eine Draufsicht auf einen Abstandshalter für die Trägerplatte nach Fig. 1,
- Fig. 10: einen Schnitt längs der Linie X-X in Fig. 9.

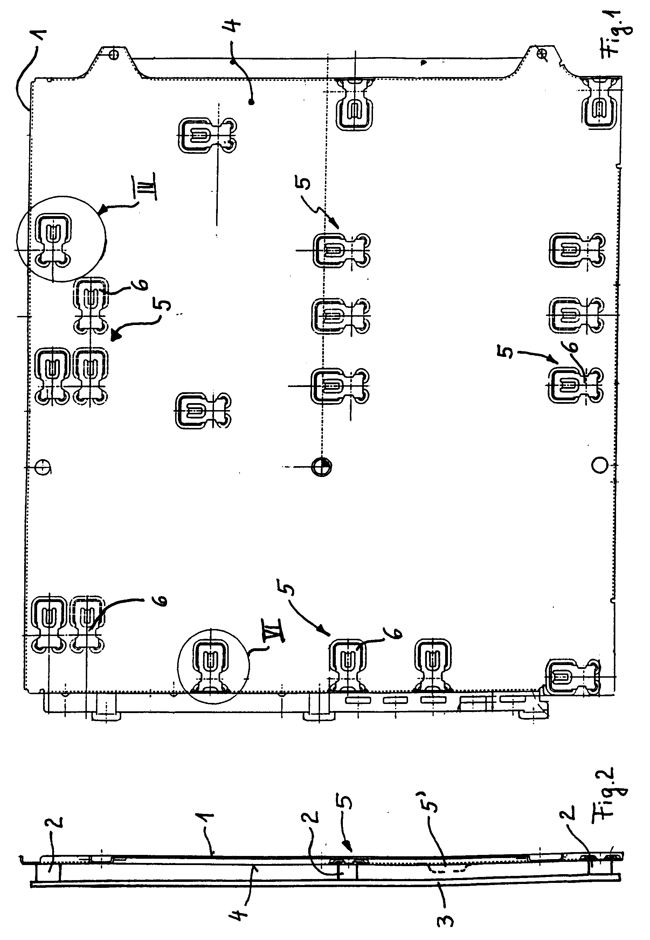

Die in Fig. 1 dargestellte Trägerplatte 1 besteht aus einem Blech, insbesondere einem beschichtetem Blech, welches zur Versteifung an den Längskanten abgekantet sein kann. Wie in Fig. 2 schematisch dargestellt, ist auf der Trägerplatte mittels Abstandshaltern 2 eine Platine 3 festgelegt, auf der nicht näher dargestellte elektronische Bauelemente angeordnet sind. Die Platine 3 ist insbesondere die Hauptplatine (Main Board) eines Computers, zum Beispiel eines PCs.

Um für unterschiedliche Main Boards mit unterschiedlichen Befestigungspunkten eine gleiche Trägerplatte 1 verwenden zu können, sind gemäß der Erfindung auf der der Platine 3 zugewandten Außenseite 4 der Trägerplatte 1 eine Vielzahl von Montagesitzen 5 ausgebildet, die je nach der zu haltenden Platine 3 und deren Befestigungspunkten mit Abstandshaltern 2 bestückt werden.

Jeder Montagesitz 5 ist aus der Ebene der Trägerplatte 1 nach Art einer Vertiefung 6 ausgeprägt, derart, daß der Boden 9 der Vertiefung auf seiner der Platine 3 zugewandten Seite mit einem Abstand a zur Außenseite 4 der Trägerplatte 1 liegt. Die ausgeprägte Vertiefung 6 dient der Aufnahme des plattenartigen Fußes 20 des Abstandshalters 2, wie er in den Fig. 9 und 10 dargestellt ist. Der Abstandshalter 2 besteht im wesentlichen aus einer etwa zylindrischen Hülse 21, deren Fuß 20 von einem in Draufsicht rechteckigen, insbesondere quadratischen Rahmen gebildet ist. Der Kopf 22 des Abstandshalters 2 ist durch ein eingerolltes Ende der Hülse 21 gebildet, wobei das eingerollte Ende eine zentrale Öffnung 23 zur Aufnahme einer selbstformenden Gewindeschraube aufweist. Um eine ausreichende Eingriffstiefe der Gewindeschraube zu gewährleisten, hat die Öffnung 23 eine Länge 1, die etwa einem Viertel der Gesamtlänge des Abstandshalters 2 entspricht.

Wie die Fig. 9 zeigt, sind die Ecken des plattenartigen Rahmens 20 gerundet, wodurch ein besseres Einschieben in den Montagesitz 5 möglich ist, wie nachfolgend noch erläutert wird.

Die den Montagesitz 5 bildende, in die Trägerplatte 1 geprägte Vertiefung 6 hat eine Breite B, die geringfügig größer als die Kantenlänge b des bevorzugt quadratischen Rahmens des Fußes 20 ist. Die Länge L der Vertiefung entspricht etwa der doppelten Kantenlänge b des quadratischen Fußes 20. Durch den quadratischen Aufbau des Fußes 20 kann der Abstandshalter 2 in allen Drehlagen in den Montagesitz 5 eingesetzt werden. Grundsätzlich sind am Fuß 20 des Abstandshalters 2 nur zwei Kanten 20a, 20b erforderlich, die von Haltenasen 10, 11 zu übergreifen sind.

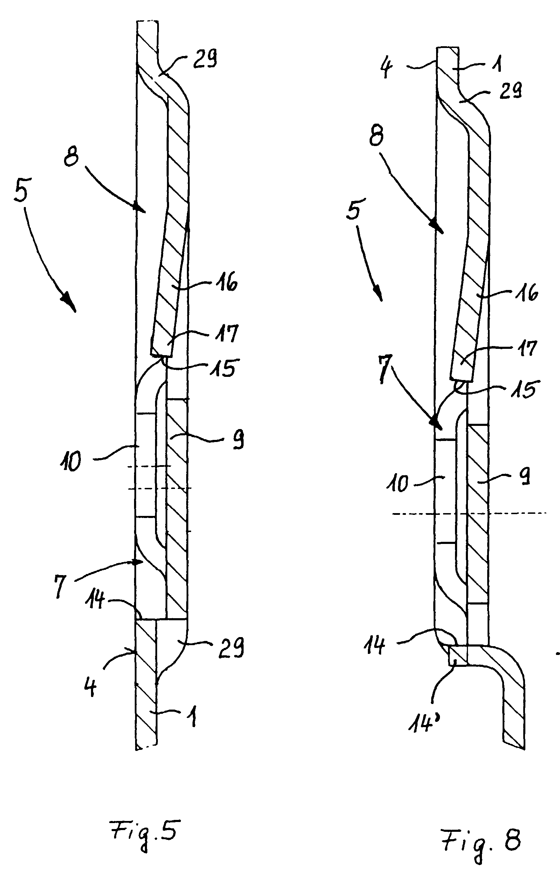

Die Vertiefung 6 läßt sich quer zu ihrer Länge L in einen Montageabschnitt 8 und einen Sitzabschnitt 7 aufteilen. Der Sitzabschnitt 7 weist an seinen Längskanten 12 und 13 je eine Haltenase 10 und 11 auf, die aneinander zugewandt sind und in der Ebene der Trägerplatte 1 liegen. Die Haltenasen 10 und 11 liegen - wie Fig. 4 zeigt - mit einem Abstand d zum Boden 9 der Vertiefung, der geringfügig größer als die Dicke D (Fig. 10) des plattenartigen Fußes 20 ist. Die zu den Längskanten 12 und 13 quer liegende Stirnkante 14 bildet eine Anschlagnase für den plattenartigen Fuß 20 des Abstandshalters 2. Auf der der Stirnkante 14 gegenüber liegenden Seite ist der Sitzabschnitt 7 von einer Anschlagnase 15 begrenzt, welche von dem freien Ende 17 einer Federzunge 16 gebildet ist.

Die Federzunge 16 ist im Boden 9 des Montageabschnitts 8 durch einen U-förmigen Freistich 18 ausgebildet, wobei gleichzeitig beim Prägen des ganzen Montagesitzes 5 die Federzunge 16 aus der Ebene des Bodens 9 in die Vertiefung 6 ausgestellt wird. Das freie Ende 17 der Federzunge 16 liegt mit geringem Abstand zur Außenseite 4 der Trägerplatte 1.

Gemäß der Erfindung wird der Montagesitz 5 bei der Fertigung der Trägerplatte in diese eingeprägt, wobei der Boden 9 über einen breiteren Verformungsstreifen 29 einteilig an die Trägerplatte anschließt. Lediglich im Bereich der Haltenasen 10 und 11 sowie der eine Anschlagnase 14 bildenden Stirnkante ist der Boden 9 von der Trägerplatte getrennt. Die Haltenasen 10 und 11 sowie die Anschlagnase 14 liegen in einer Ebene mit der Trägerplatte bzw. deren Außenseite 4.

Die Haltenasen 10 und 11 liegen außermittig zum Montageabschnitt 7, um in den Ecken der Längskanten 12 und 13 zur Querkannte 14 einen ausreichend breiten Verformungsabschnitt 29 zu ermöglichen. Der Verformungsabschnitt 29 gewährleistet eine materialschonende Verformung unter Vermeidung von Materialrissen und dergleichen. Die Haltenasen 10 und 11 übergreifen etwa die halbe Länge der zugewandten Kanten 20a, 20b des Fußes 20. Die quer zu den Rändern liegenden Flanken 24 und 25 der Haltenasen liegen unter einem Öffnungswinkel 26 von etwa 20° zueinander. Die Größe des Montageabschnittes 8 des Montagesitzes 5 entspricht bevorzugt etwa den Abmessungen des Fußes 20 des Abstandshalters 2. Da der Boden 9 des Montageabschnittes im wesentlichen über seinen gesamten Umfang über den Verformungsstreifen 29 in die Trägerplatte übergeht, ergibt sich eine trichterähnliche Gestalt, die das Einsetzen des Abstandshalters 2 mit seinem Fuß 20 in den Montageabschnitt 8 erleichtert. Der Abstandshalter 2 wird dann gegen die Kraft der Federzunge 16 niedergedrückt und in Richtung auf die Stirnkante 14 unter die Haltenasen 10 und 11 verschoben, bis die Federzunge 16 wieder ausfedert und den Fuß 20 bzw. den Abstandshalter 2 in seiner Lage hinter den Haltenasen 10 und 11 lagegenau sichert.

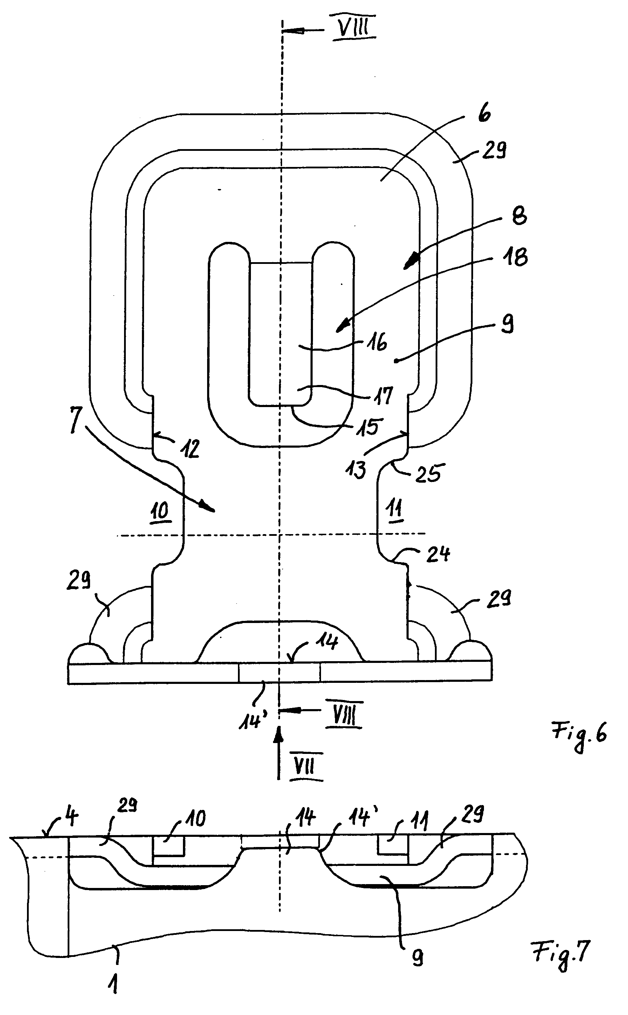

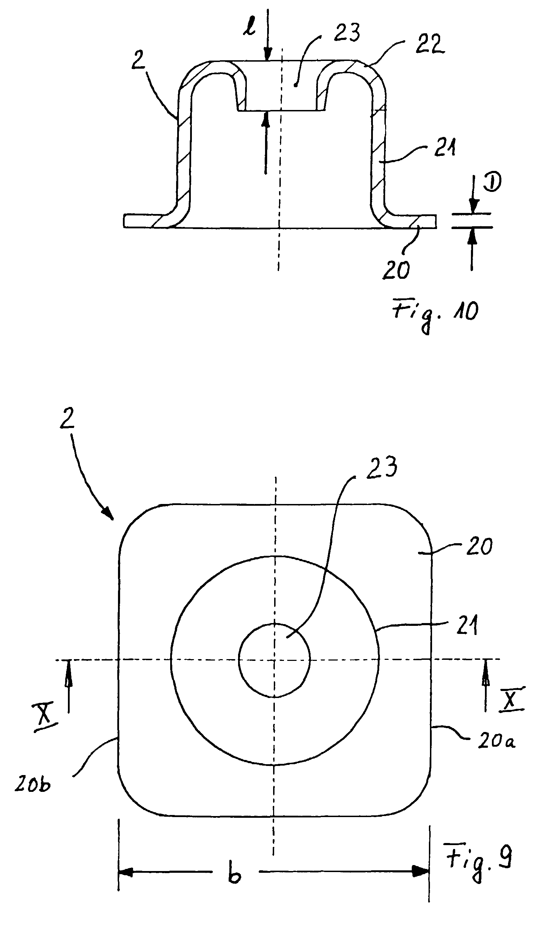

Liegt ein Montagesitz 5 nahe einer Außenkante 14' der Trägerplatte 1, so wird die Anordnung so getroffen, daß der abgekantete Rand 14' gleichzeitig die eine Anschlagnase bildende Stirnkante 14 des Montagesitzes 5 bildet. Wie die Fig. 6 bis 8 zeigen, liegt die Stirnkante 14 in Flucht mit dem abgekanteten Rand 14' der Trägerplatte 1, so daß Verformungszonen der Stirnkante 14 zur Trägerplatte 1 entfallen. Dennoch ist eine ausreichende Stabilität gewährleistet.

## Patentansprüche

1. Trägerplatte mit Abstandshaltern für eine parallel zur Trägerplatte (1) festzulegende Platine (3) mit elektronischen Bauelementen, wobei jeder Abstandshalter (2) mit einem Fuß (20) an einem Befestigungspunkt (5) auf der zugewandten Seite (4) der Trägerplatte (1) festliegt und mit einem Kopf (22) an einem vorgegebenen Befestigungspunkt der Platine (3) festzulegen ist, dadurch gekennzeichnet, daß der Fuß (20) des Abstandshalters (2) plattenartig ausgebildet ist und etwa parallel zur Trägerplatte (1) liegt, daß der plattenartige Fuß (20) an mindestens zwei Kanten (20a, 20b) von Haltenasen (10, 11) der Trägerplatte (1) übergriffen ist und in dieser Lage durch Anschlagnasen (14, 15) der Trägerplatte (1) gesichert ist.

2. Trägerplatte nach Anspruch 1,
dadurch gekennzeichnet, daß die Nasen (10, 11, 14, 15) aus der Trägerplatte (1) ausgeprägt sind und in der Ebene der Trägerplatte (1) liegen.

3. Tragerplatte nach Anspruch 1,
dadurch gekennzeichnet, daß die Nasen (10, 11, 14, 15) aus der Trägerplatte (1) ausgeprägt sind und aus der Ebene der Trägerplatte (1) hervorstehen.

4. Trägerplatte nach einem der Ansprüche 1 bis 3,
dadurch gekennzeichnet, daß eine Anschlagnase (15) von dem vorderen Ende (17) einer aus der Trägerplatte (1) ausgeprägten Federzunge (16) gebildet ist.

5. Trägerplatte nach einem der Ansprüche 1 bis 4,
dadurch gekennzeichnet, daß der plattenartige Fuß (20) etwa rechteckig, vorzugsweise etwa quadratisch ist.

6. Trägerplatte nach einem der Ansprüche 1 bis 5,
dadurch gekennzeichnet, daß der plattenartige Fuß (20) das untere Ende einer zylindrischen Hülse (21) rahmenartig umgibt.

7. Trägerplatte nach einem der Ansprüche 1 bis 6,
dadurch gekennzeichnet, daß der Kopf (22) des Abstandshalters (2) durch ein nach innen eingerolltes Ende (23) einer Hülse (21) gebildet ist.

8. Trägerplatte nach einem der Ansprüche 1 bis 7,
dadurch gekennzeichnet, daß der Abstandshalter (2) mit seinem Fuß (20) und seinem Kopf (22) aus einem Blech geprägt ist.

9. Trägerplatte nach einem der Ansprüche 1 bis 8,
dadurch gekennzeichnet, daß der Montagesitz (5) für den Fuß (20) des Abstandshalters (2) als Vertiefung (6) in der Trägerplatte (1) eingeprägt ist.

10. Trägerplatte nach Anspruch 9,
dadurch gekennzeichnet, daß der Boden (9) des Montagesitzes (5) mit Abstand (a) zu der der Platine (3) zugewandten Außenseite (4) der Trägerplatte (1) liegt.
